# EUROPÄISCHE PATENTSCHRIFT

(11) **EP 0 303 108 B1**
(45) Veröffentlichungstag und Bekanntmachung des Hinweises auf die Patenterteilung: **23.02.1994**
(21) Anmeldenummer: 88112209.7
(22) Anmeldetag: 28.07.1988
(51) Int. Cl.: G03F 7/004

(54) **Lichtempfindliches Gemisch, daraus hergestelltes lichtempfindliches Kopiermaterial und Verfahren zur Herstellung von negativen Reliefkopien**
Light-sensitive composition, registration material prepared therefrom and process for the production of negative relief images
Composition photosensible, matériau pour l'enregistrement préparé à partir de cette composition et procédé pour la fabrication d'images négatives en relief

(30) Priorität: 05.08.1987 DE 3725949
(43) Veröffentlichungstag der Anmeldung: 15.02.1989
(73) Patentinhaber: HOECHST AKTIENGESELLSCHAFT, 65926 Frankfurt am Main (DE)
(72) Erfinder: Stahlhofen, Paul, Dr. Dipl.-Chem., D-6200 Wiesbaden (DE); Frass, Hans Werner, Dr. Dipl.-Chem., D-6200 Wiesbaden (DE)

(56) Entgegenhaltungen:
- EP-A- 0 133 216
- JOURNAL OF THE AMERICAN CHEMICAL SOCIETY. vol. 73, no. 7, 06 Juli 1951, GASTON, PA US Seiten 2990 - 2992; SCHAEFER F.C. et al: "Cyanuric Chloride Derivatives. IV. Aryloxy-s-triazines"

## Beschreibung

Die Erfindung betrifft ein lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und einen symmetrischen Triazin-alkyl(aryl)-ether als thermische Härtung fördernde Substanz enthält. Die Erfindung betrifft auch ein Kopiermaterial aus einem Schichtträger und einer lichtempfindlichen Schicht, die aus dem Gemisch besteht sowie Verfahren zur Herstellung von negativen Reliefkopien durch Belichten, Erwärmen, vollflächiges Belichten, Entwickeln und gegebenenfalls Tempern eines normalerweise positiv arbeitenden Kopiermaterials.

Positiv arbeitende lichtempfindliche Gemische, deren bildmäßig belichtete Bereiche in einer Entwicklerlösung löslich werden und in der die unbelichteten Bereiche unlöslich sind, sind bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Lichtempfindliche Gemische auf Basis säurespaltbarer Verbindungen sind ebenfalls bekannt. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine. Als Bindemittel werden auch Harze mit alkalilöslich machenden Gruppen verwendet.

Es ist auch bekannt, daß man ein normalerweise positiv arbeitendes Kopiermaterial auf Basis von o-Chinondiaziden in Gegenwart geeigneter Zusatzstoffe durch eine bestimmte Folge von Behandlungen als negativ arbeitendes Kopiermaterial einsetzen kann. In der GB-A 2,082,339 ist ein derartiges Umkehrverfahren beschrieben, bei dem ein lichtempfindliches Gemisch, bestehend aus einem o-Chinondiazid und mindestens einem Resol, als negativ arbeitendes Aufzeichnungsmaterial benutzt wird. In der DE-A 25 29 054, entsprechend US-A 4 104 070, werden Resistschichten auf Basis von 1,2-Chinondiaziden für ein Umkehrverfahren beschrieben, die als Zusatzstoff Hydroxyethylimidazoline enthalten. Ein ähnliches Material mit einem Gehalt an sekundären oder tertiären Aminen wird in der US-A 4 196 003 beschrieben. In EP-A 0 133 216, entsprechend US-A 4 581 321 wird ein Umkehrverfahren beschrieben, welches als Zusatz zur o-Chinondiazid-haltigen Kopierschicht einen Hexamethylolmelaminether enthält, der vorzugsweise als Vernetzungsmittel bei Polymerreaktionen Verwendung findet, während in EP-A 0 131 238, entsprechend US-A 4 576 901, ein Umkehrverfahren beschrieben wird, dessen lichtempfindliches Material keinen der oben erwähnten basischen oder sauren Zusätze erfordert.

Bekannt ist ferner ein Positiv-Negativ-Umkehrverfahren auf Basis säurespaltbarer Verbindungen anstelle von 1,2-Chinondiaziden, wie es in EP-A 0 082 463, entsprechend US-A 4 506 006 beschrieben ist.

Die bekannten Umkehrverfahren enthalten im Prinzip die gleiche Folge von Verarbeitungsschritten, wobei man nach der bildmäßigen Belichtung die Druckplatte erwärmt, nach dem Abkühlen nochmals ohne Vorlage nachbelichtet und dann mittels eines wäßrig-alkalischen Entwicklers entwickelt.

Die bekannten Umkehrverfahren beruhen darauf, daß die entstandenen Lichtzersetzungsprodukte beim Erwärmen ein unlösliches Reaktionsprodukt ergeben. Diese thermische Härtung erfolgt vorzugsweise in Gegenwart bestimmter basischer oder saurer Zusätze zur Kopierschicht oder in Gegenwart bestimmter Vernetzungsmittel mit multifunktionalen reaktionsfähigen Gruppen.

Derartige Zusätze haben jedoch im allgemeinen einen nachteiligen Einfluß auf die Lagerfähigkeit des Kopiermaterials und auf bestimmte kopiertechnische Eigenschaften, wie z.B. die Lichtempfindlichkeit und den Bildkontrast nach dem Belichten. Auch ist für viele Anwendungszwecke die zur Bildumkehr erforderliche Temperatur unerwünscht hoch, die Dauer des Erhitzens bei niedrigerer Temperatur zu lang oder der Temperaturbereich zur Umkehrung zu klein.

Das in EP-A 0 133 216 beschriebene Umkehrverfahren enthält als wesentlichen Bestandteil in der Kopierschicht neben einem 1,2-Chinondiazid einen Ether des Hexamethylolmelamins. Obwohl derartige Melaminether die Bildumkehr eines normalerweise positiv arbeitenden lichtempfindlichen Materials während der thermischen Behandlung an den belichteten Bildbereichen in vorteilhafter Weise fördern, haben sie den Nachteil, daß die Temperaturtoleranzen des Umkehrspielraumes nicht genügend groß sind, wodurch es zu unterschiedlichen Kopierergebnissen kommen kann. Ein weiterer Nachteil ist die mangelhafte Lagerfähigkeit der Druckplatten infolge der anwesenden reaktionsfähigen Ether-Gruppen, insbesondere bei angehobenen Temperaturen, was zu einer unerwünschten vorzeitigen Vernetzung und Brauchbarkeitsbeeinträchtigung führt.

In der älteren deutschen Patentanmeldung, Aktenzeichen P 37 11 263.5 wird ein sowohl positiv als auch negativ arbeitendes lichtempfindliches Gemisch vorgeschlagen, das als die thermische Härtung fördende Substanz einen symmetrischen Triazin-alkyl(aryl)-ether enthält, der eine Dialkylaminogruppe an einem C-Atom tragen kann. Nachteilig ist, daß infolge der starken Basizität dieser Gruppierung beim Belichten in Gegenwart geeigneter photochemischer Säurebildner entstehende Säure nicht mehr ausreicht, um in den belichteten Schichtbereichen eine Farbänderung der mit einem Indikatorfarbstoff eingefärbten Kopierschicht zu erhalten. Der fehlende Bildkontrast führt in der Praxis zu Fehlkopien, vor allem bei der Belichtung in den sogenannten Repetiermaschinen, in denen ein einziges Diapositv, z.B. für den Etikettendruck, mehr fach nebeneinander auf die Druckplatte projiziert wird. Da der Kontrast zwischen Bild- und Nichtbildstellen auf der Druckplatte nach dem Belichten nur schwach ist, insbesondere bei ihrer Betrachtung in Gegenwart von gelbem Licht, wie es in den Kopierräumen bei der Verarbeitung von lichtempfindlichen Druckplatten erforderlich ist, kann es sehr schwierig sein, genaue und platzsparende Einpaß-Arbeiten durchzuführen. Das ferner vorgeschlagene 2,4,6-Triphenoxy-s-triazin besitzt demgegenüber zwar eine geringere Basizität und hat somit keinen wie oben beschriebenen nachteiligen Einfluß auf die Entstehung des Bildkontrastes nach dem Belichten, hat aber den Nachteil, daß es in den organischen Lösungmitteln, wie sie üblicherweise zur Beschichtung verwendet werden, relativ schwer löslich ist. Dies führt beim Trocknen der auf den Schichtträger aufgetragenen Beschichtungslösung zu einer vorzeitigen Ausfällung dieser Verbindung, was zu einer ungleichmäßigen und damit ungenügenden Beschichtungsqualität führt.

Aufgabe der Erfindung war es deshalb, ein lichtempfindliches Gemisch, ein hieraus hergestelltes Kopiermaterial und ein Umkehrverfahren mittels dieses Materials zu schaffen, das die oben beschriebenen Nachteile nicht besitzt, sondern eine gute Lagerfähigkeit auch bei angehobener Temperatur besitzt und einen relativ hohen Bearbeitungsspielraum in seiner thermischen Behandlung aufweist.

Gegenstand der Erfindung ist ein lichtempfindliches Gemisch, das im wesentlichen ein Wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und einen symmetrischen Triazin-alkyl(aryl)-ether als die thermische Härtung fördernde Substanz enthält, dadurch gekennzeichnet, daß als thermische Härtung fördernde Substanz eine Verbindung der allgemeinen Formel I 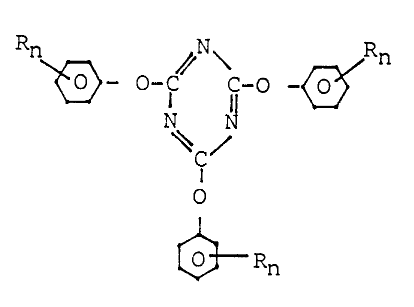
vorhanden ist, worin
- R: Alkyl, Allyl, Alkoxy, Alkoxycarbonyl, Alkoxycarbonylalkenyl, mit jeweils 1-4 Kohlenstoffatomen in der Alkyl- oder Alkenyl-Gruppe, Aryloxy, Halogen oder die Nitrogruppe und
- n: 1 bis 3
bedeuten. Vorzugsweise ist eine Verbindung der allgemeinen Formel I vorhanden, worin
- R: Methyl, Isobutyl, Ethoxy, Ethoxycarbonyl, Methoxycarbonylethenyl, Brom oder die Nitro-Gruppe und
- n: 1 oder 3
bedeuten.

Als besonders vorteilhaft haben sich 2,4,6-Tris(4-methyl-phenoxy)-s-triazin, 2,4,6-Tris-(4-ethoxycarbonyl-phenoxy)-s-triazin und 2,4,6-Tris(2,4,6-tribromphenoxy)-s-triazin bewährt.

Die Herstellung der Aryloxy-s-triazine ist im Prinzip bekannt und beispielsweise in "The Journal of the American Chemical Society", Vol. 73 (1951), Seite 2990 beschrieben.

Die Herstellung erfolgt am vorteilhaftesten durch Umsetzung von 1 Mol Cyanursäurechlorid mit 3 Mol eines entsprechend substituierten Phenols. Zu diesem Zweck werden die beiden Reaktionspartner in Dioxan gelöst, man gibt langsam und unter gutem Rühren bei Raumtemperatur 3 Mol fein gepulvertes Natriumhydroxid hinzu und hält anschließend das Reaktionsgemisch unter fortgesetztem Rühren noch ca. 3 Stunden bei 80 °C. Nach Beendigung der Umsetzung wird das Reaktionsgemisch in mit Salzsäure leicht angesäuertes Wasser eingerührt. Hierbei fällt das Reaktionsprodukt in guter Ausbeute aus.

Die erfindungsgemäßen Phenylkern substituierten Trisaryloxy-s-triazine zeichnen sich durch eine gute Löslichkeit in den üblichen organischen Lösungsmitteln aus. Sie neigen auch nicht zu einer vorzeitigen Kristallisation während der Trocknung der auf einen Schichtträger aufgebrachten Beschichtungslösung in der Beschichtungsanlage.

Die Konzentration der erfindungsgemäßen symmetrischen Triazine in dem lichtempfindlichen Gemisch kann in relativ weiten Grenzen schwanken. Im allgemeinen liegt der Anteil bei 0,5 bis 30, vorzugsweise zwischen 1 und 15 Gewichtsprozent, bezogen auf das Gewicht der nicht-flüchtigen Bestandteile des lichtempfindlichen Gemisches.

Von großem Vorteil ist, daß die erfindungsgemäßen s-Triazine dem lichtempfindlichen Gemisch und dem damit hergestellten Kopiermaterial während des Positiv-NegativUmkehrschrittes eine gute Beständigkeit gegenüber unerwünschter Wärmeeinwirkung verleihen. Hieraus resultiert ein relativ großer Bearbeitungsspielraum während der Wärmebehandlung für das Umkehrverfahren, ohne daß hierbei die Tonwertwiedergabe, auch bei Temperaturschwankungen, nachteilig beeinflußt wird. Dies führt zu einer erheblichen Erleichterung der Verfahrensweise zur Herstellung von Druckformen. Vorteilhaft ist ferner, daß in Gegenwart der erfindungsgemäßen s-Triazine der für die Praxis erforderliche Bildkontrast nach dem Belichten nicht nachteilig beeinflußt wird.

Brauchbare Sensibilisatoren, die in dem erfindungsgemäßen Gemisch bzw. dem daraus hergestellten Kopiermaterial verwendet werden können, sind 1,2-Chinondiazidsulfonsäureester und -amide, 1,2-Chinondiazid-carbonsäureester und -amide, die nach dem Bestrahlen mit aktinischem Licht in wäßrig-alkalischen Lösungen löslich werden. Hierzu zählen die Umsetzungsprodukte von 1,2-Benzo- oder 1,2-Naphthochinon-diazid-4 oder -5-sulfonsäure bzw. deren Säurechloriden mit Phenol-Aldehyd/Aceton-Kondensationsprodukten oder mit Polymeren aus p-Hydroxystyrol, p-Aminostyrol oder deren Copolymeren. Besonders brauchbare Sensibilisatoren sind die 1,2-Chinondiazidsulfonsäure-4-ester.

Als Ester der 1,2-Chinondiazidderivate kommen die bekannten Umsetzungsprodukte der Säuren oder ihrer Halogenide mit Phenolen, insbesondere mehrwertigen Phenolen in Betracht, zum Beispiel mit 2,3,4-Trihydroxy-benzophenon, 2,4-Dihydroxy-benzophenon oder 4,4-Bis-(4-hydroxyphenyl)-valeriansäurebutylester. Ganz besonders vorteilhaft hat sich das Veresterungsprodukt aus 1 Mol 4-(2-Phenyl-prop-2-yl)phenol und 1 Mol Naphthochinon-(1,2)-diazid-(2)-4-sulfonsäurechlorid bewährt.

Die Menge an o-Chinondiazidverbindungen beträgt im allgemeinen 3 bis 50, bevorzugt 10 bis 30 Gewichtsprozent, bezogen auf die nicht-flüchtigen Bestandteile des lichtempfindlichen Gemisches bzw. der Kopierschicht.

Als lichtempfindliche Komponenten, die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphospor-, Hexafluorantimon- und -arsen-säure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen und einem aromatischen bzw. ungesättigten Substituenten im Triazinkern, wie sie in den DE-A 27 18 259 und 33 37 024 beschrieben sind, bevorzugt. Ebenso gut geeignet sind die in den DE-A 28 51 471 und 29 49 396 beschriebenen 2-Trichlormethyl-1,3,4-oxdiazole. Die Wirkung dieser halogenhaltigen Verbindungen kann auch durch bekannte Sensibilisatoren spektral beeinflußt und gesteigert werden.

Beispiele für geeignete photochemische Säurebildner sind:
4-Methyl-6-trichlormethyl-2-pyron, 4-(3,4,5-Trimethoxystyryl)-6-trichlormethyl-2-pyron, 4-(4-Methoxy-styryl)-6-(3,3,3-trichlorpropenyl)-2-pyron, 2-Trichlormethylbenzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethylbenzol, Tris-dibrommethyl-s-triazin, 2-(6-Methoxy-naphth-2-yl)-, 2-(Naphth-1-yl)-, 2-(Naphth-2-yl)-, 2-(4-Ethoxy-ethylnaphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen aufgeführten Verbindungen.

Die Menge des photochemischen Säurebildners kann je nach seiner chemischen Natur und der Zusammensetzung der Schicht ebenfalls sehr verschieden sein. Günstige Ergebnisse werden erhalten mit etwa 0,5 bis 20 Gewichtsprozent, bezogen auf den Gesamtfeststoff. Bevorzugt sind 1,0 bis 12 Gewichtsprozent. Besonders für lichtempfindliche Schichten von Dicken über 0,01 mm empfiehlt es sich, relativ wenig Säurespender zu verwenden.

Als durch Säure spaltbare Verbindungen sind in erster Linie zu nennen:
A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können.
B) Oligomer- oder Polymerverbindungen mit wiederkehrenden Acetal- und/oder Ketalgruppierungen in der Hauptkette und
C) Verbindungen mit mindestens einer Enolether- oder N-Acyliminocarbonatgruppierung.

Durch Säure spaltbare Verbindungen des Typs (A) als Komponenten lichtempfindlicher Gemische sind in der US-A 4 101 323 und in der EP-A 0 022 571 ausführlich beschrieben; Gemische, die Verbindungen des Typs (B) enthalten, sind in den DE-C 23 06 248 und 27 18 254 sowie in der US-A 3 779 778 beschrieben; Verbindungen des Typs (C) werden in den EP-A 0 006 626 und 0 006 627 beschrieben.

Der Anteil der spaltbaren Verbindung kann variiert werden zwischen 4 und 50, bevorzugt werden 5 bis 30 Gewichtsprozent, bezogen auf den Gesamtfeststoff.

Die lichtempfindlichen Gemische enthalten ferner vorzugsweise ein polymeres, wasserunlösliches harzartiges Bindemittel, das sich in den für das Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Bindemittel auch bei dem erfindungsgemäßen Verfahren als vorteilhaft erwiesen. Die Novolake können auch in bekannter Weise durch Umsetzung eines Teils ihrer Hydroxygruppen, zum Beispiel mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenylharze, die durch Kondensation aus Phenolen und Aldehyden oder Ketonen hergestellt werden, Mischpolymerisate aus Styrol und Maleinsäureanhydrid, Polyvinylphenole oder Mischpolymerisate der Acrylsäure oder Methacrylsäure, insbesondere mit Acryl- oder Methacrylsäurephenolestern, bevorzugt.

Die Art und Menge der Bindemittel kann je nach Anwendungszweck verschieden sein; bevorzugt werden Anteile am Gesamtfeststoff zwischen 90 und 30, besonders bevorzugt 85 - 55 Gewichtsprozent eingesetzt.

Zusätzlich können noch zahlreiche andere Harze mitverwendet werden, wie Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und nach dem Einfluß auf die Entwicklungsbedingungen. Er beträgt im allgemeinen nicht mehr als 50, bevorzugt etwa 2 bis 35 Gewichtsprozent vom eingesetzten Bindemittel. In geringen Mengen kann das lichtempfindliche Gemisch für spezielle Erfordernisse wie Flexibilität, Haftung, Glanz und Färbung, außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Bis- oder Trishalogenmethyl-s-triazine oder Diazoniumverbindungen in Form ihrer Salze mit komplexen Säuren wie Borfluorwasserstoffsäure oder Hexafluorphosphorsäure.

Die Erfindung betrifft auch ein lichtempfindliches, normalerweise positiv arbeitendes Kopiermaterial, aus einem Schichtträger und einer aufgebrauchten lichtempfindlichen Schicht aus einem Gemisch nach den Ansprüchen 1 bis 4.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethyl-keton, cnlorierte Kohlenwasserstoffe wie Trichlorethylen und 1,1,1 Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag. Belichtet wird mit den in der Technik üblichen Lichtquellen.

Die Erfindung betrifft ferner ein Verfahren zur Herstellung negativer Reliefkopien, bei dem man ein normalerweise positiv arbeitendes lichtempfindliches Kopiermaterial aus einem Schichtträger mit einer lichtempfindlichen Schicht aus einem Gemisch nach Ansprüchen 1 bis 4 verwendet, bildmäßig belichtet, danach erwärmt, nach dem Abkühlen vollflächig belichtet, dann mittels eines wäßrig-alkalischen Entwicklers entwickelt und gegebenenfalls anschließend tempert.

Das erfindungsgemäße Verfahren ist auch zur Herstellung von Reliefkopien, die sowohl negative als auch positive Bilder wiedergeben geeignet. Hierzu wird das Kopiermaterial unter einer Negativ-Vorlage bildmäßig belichtet und danach erwärmt und dann nach dem Abkühlen unter einer Positiv-Vorlage in den noch nicht bildmäßig belichteten Bereichen belichtet und anschließend mittels eines wäßrig-alkalischen Entwicklers entwickelt.

Zur Umkehrbehandlung wird das Kopiermaterial nach dem bildmäßigen Bestrahlen bzw. Belichten unter einer Negativ-Vorlage ohne weitere Zwischenbehandlung erwärmt. Das Erwärmen kann durch Bestrahlung, Konvektion, durch Kontakt mit erwärmten Flächen, zum Beispiel Walzen, oder Tauchen in ein erwärmtes Bad einer inerten Flüssigkeit, zum Beispiel Wasser, erfolgen. Die Erwärmungstemperatur liegt zwischen 80 und 150, insbesondere zwischen 100 bis 130 °C. Derartige Temperaturen werden von den Gemischen vertragen, ohne daß die Eigenschaften der unbelichteten Bereiche wesentlich verändert werden. Die Dauer des Erwärmens des Kopiermaterials kann je nach Art der Wärmeeinwirkung sehr unterschiedlich sein. Bei Übertragung durch ein Wärmemedium liegt sie zwischen 10 Sekunden und 10 Minuten, besonders zwischen 1 und 3 Minuten.

Nach dem Erwärmen und Abkühlen wird die Druckplatte einer Totalbelichtung unterworfen, um die noch lichtempfindlichen Schichtbereiche vollständig in ihre Lichtzersetzungsprodukte umzuwandeln. Die Nachbelichtung kann vorteilhaft mit Hilfe der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen worden waren. Als Entwickler sind vorzugsweise wäßrige Lösungen von alkalischen Substanzen abgestufter Alkalität, zum Beispiel von Alkaliphosphaten, -silikaten, -carbonaten oder -hydroxiden geeignet. Der pH-Bereich liegt im allgemeinen zwischen 10 und 14. Der Entwickler kann ferner Netzmittel oder kleinere Mengen organischer Lösungsmittel enthalten. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von z.B. mehreren Stunden erfolgen, ohne daß die gehärteten Schichtbereiche angegriffen werden.

Falls erforderlich kann zur Erhöhung der Druckauflage ein Tempern, d.h. ein Erhitzen der Druckformen durchgeführt werden, was innerhalb von etwa 5 Minuten in einem Temperaturbereich von etwa 210 - 250 °C erfolgt.

Das erfindungsgemäße Kopiermaterial besitzt eine gute Lagerfähigkeit, auch bei angehobener Temperatur. Die Aushärtung der bildmäßig belichteten Schichtbereiche in der Wärme erfolgt relativ schnell, die Temperatur des für den Umkehrschritt erforderlichen Erwärmens ist niedriger und die Verweilzeit bei erhöhter Temperatur wesentlich kürzer als bei den bekannten Materialien.

Das Verfahren hat ferner den Vorteil, daß in Gegenwart der erfindungsgemäß verwendeten s-Triazine in der Kopierschicht die Temperaturtoleranzen des Umkehrspielraums relativ groß sind, wodurch die Tonwertwiedergabe auch bei großen Temperaturschwankungen während des Umkehrschrittes nicht nachteilig beeinflußt wird.

Die erfindungsgemäßen Phenylkern substituierten 2,4,6-Tris-(aryloxy)-s-triazine zeichnen sich durch eine gute Löslichkeit in den für die Beschichtung üblichen Lösungsmitteln aus. Ferner wird der nach der Belichtung des Kopiermaterials erforderliche Bildkontrast durch die erfindungsgemäßen Verbindungen nicht nachteilig beeinflußt.

Wie schon erwähnt lassen sich mit den erfindungsgemäßen Kopiermaterialien außer der Herstellung einer Negativ-Kopie von der normalerweise positiv-arbeitenden Kopierschicht auch vorteilhaft verschiedene Kombinationsmöglichkeiten beim Zusammenkopieren von Strich-und Rasterfilmen verwirklichen (Photocomposing). So kann man beispielsweise unmittelbar nach der ersten bildmäßigen Belichtung unter einer Negativ-Vorlage nachträglich an den noch nicht vom Licht getroffenen Schichtbereichen, die während der ersten Belichtung durch eine Maske abgedeckt waren, mit Hilfe einer Positiv-Vorlage zusätzlich noch ein weiteres Strich- oder Rasterbild einkopieren. Die so belichtete Druckplatte wird anschließend ohne weitere Zwischenschritte entwickelt. Man erhält auf diese Weise die fertige Druckform.

Dementsprechend belichtet man in Abänderung des erfindungsgemäßen Verfahrens das Kopiermaterial zum Zusammenkopieren von Negativ- und Positivkopien nach dem Abkühlen mit Hilfe weiterer Vorlagen in den noch nicht belichteten, abgedeckten Schichtbereichen bildmäßig und entwickelt mittels eines wäßrig-alklischen Entwicklers.

Zusätzliche Behandlungsschritte mit Flüssigkeiten oder eine besondere Zusammensetzung des lichtempfindlichen Materials sind nicht erforderlich. Der einzige zusätzliche Behandlungsschritt, das Erwärmen, kann zumeist mit vorhandenen Trocknungsgeräten bequem durchgeführt werden. Die Nachbelichtung ohne Vorlage wird am einfachsten wieder mit der Kopierlichtquelle durchgeführt.

Das erfindungsgemäße Verfahren kann zum Beispiel zur Herstellung von Druckformen für den Hoch-, Tief- und Flachdruck sowie von Photoresistschablonen für die substraktive und additive Leiterplattenherstellung, für die galvanische Herstellung von Nickelrotationszylindern oder für die Maskenherstellung in der Mikroelektronik nach der Lift-off-Technik eingesetzt werden.

Die folgenden Beispiele beschreiben bevorzugte Ausführungsformen des erfindungsgemäßen Verfahrens. Prozentzahlen und Mengenverhältnisse sind, wenn nichts anderes angegeben ist, in Gewichtseinheiten zu verstehen.

### Beispiel 1:

Mit einer Lösung von
1,800 Gt des Veresterungsproduktes aus 1 Mol 4-(2-Phenyl-prop-2-yl)-phenol und 1 Mol Naphthochinon(1,2)-diazid-(2)-4-sulfonsäurechlorid,
1,500 Gt eines Kresol-Formaldehyd-Novolaks mit einem Erweichungspunkt von 115 - 125 °C,
6,000 Gt eines Copolymerisats aus Brenzcatechinmethacrylsäure und Styrol im Molverhältnis 70 : 30
0,040 Gt 2,4-Bis-trichlormethyl-6-p-stilbenyl-s-triazin
0,900 Gt 2,4-Dihydroxybenzophenon
0,500 Gt 2,4,6-Tris-(4-ethoxycarbonyl-phenoxy)-s-triazin und
0,070 Gt Kristallviolett in
90,00 Gt Propylenglykolmonomethylether und
60,00 Gt Tetrahydrofuran
wurde eine elektrolytisch aufgerauhte und anodisierte Aluminiumplatte beschichtet. Der anodisierte Aluminiumträger war vor dem Aufbringen der Lösung mit einer wäßrigen Lösung von Polyvinylphosphonsäure behandelt worden, wie es in der DE-C 16 21 468, entsprechend US-A 4 153 461, beschrieben ist.

Das so hergestellte vorsensibilisierte Kopiermaterial mit einem Trockenschichtgewicht von ca. 2,3 g/m² wurde unter einer transparenten Positiv-Vorlage mit Hilfe einer Metall-Halogenid-Lampe von 500 Watt bei einem Lampenabstand von 103 cm mit 60 Takten bildmäßig belichtet und anschließend mit einer 4 %igen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Kopiermaterials wurde wie folgt als Negativ-Druckplatte verarbeitet. Zu diesem Zweck wurde die Probe unter einer negativen Vorlage wie oben angegeben belichtet, anschließend 2 Minuten auf 130 °C erwärmt und dann ohne Vorlage dieselbe Zeit wie bei der bildmäßigen Belichtung nachbelichcet. Nach Entwickeln im oben beschriebenen Entwickler innerhalb der gleichen Zeit entstand das Umkehrbild der Vorlage.

Eine andere Möglichkeit der Verarbeitung ist das nachträgliche Einkopieren von Strich- oder Rastervorlagen auf eine bereits bildmäßig belichtete Druckplatte nach dem Photocomposing-Verfahren. Zu diesem Zweck wird das vorbeschriebene vorsensiblisierte Kopiermaterial zunächst unter einer Negativ-Vorlage, wie oben angegeben, bildmäßig belichtet, anschließend 2 Minuten auf 130 °C erwärmt, dann an den noch nicht vom Licht getroffenen, d.h. abgedeckten Schichtbereichen unter einem Diapositiv nochmals belichtet. Das so mehrmals belichtete Material wird ohne weitere Zwischenschritte entwickelt, wodurch man die fertige Druckplatte erhält.

Ein großer Vorteil gegenüber den bisher bekannten Umkehrplatten und -verfahren ist der relativ große Behandlungsspielraum während des Erwärmungungsschrittes. Dies wird deutlich, wenn die hergestellte normalerweise positiv arbeitende lichtempfindliche Druckplatte unter einer Negativ-Vorlage in Gegenwart eines in der Offsetkopie üblichen Testkeils, beispielsweise des UGRA-Offset-Testkeils 1982, bildmäßig belichtet und anschließend der zur Bildumkehr notwendige Erwärmungsschritt durchgeführt wird.

Wird das Erwärmen der bildmäßig belichteten Druckplatte beispielsweise während 2 Minuten durchgeführt, so kann die Temperatur zwischen 105 und 150 °C variiert werden, ohne daß an dem resultierenden Testbild nach der anschließenden vollflächigen Nachbelichtung und Entwicklung eine wesentliche Veränderung sichtbar wird. Diese große Temperaturtoleranz des eigentlichen Umkehrschrittes während der Verarbeitung kommt der Praxis sehr entgegen, da die kopiertechnischen Eigenschaften, wie beispielsweise die Tonwertwiedergabe, auch bei relativ großen Temperaturschwankungen, wie sie bei den in der Praxis üblichen Wärmeöfen oder automatischen Conversionsgeräten durchaus vorkommen können, nicht nachteilig beeinflußt wird.

Wird das erfindungsgemäß verwendete 2,4,6-Tris-(4-ethoxy-carbonylphenoxy)-s-triazin beispielsweise durch die gleiche Menge eines Hexamethylolmelaminhexamethylethers gemäß EP-A-0 133 216 ersetzt und nach dem bildmäßigen Belichten unter derselben Testvorlage ebenfalls während zwei Minuten der Erwärmungsschritt durchgeführt, so resultiert lediglich ein Behandlungsspielraum von etwa 20 °C.

Die ausgezeichnete Lagerfähigkeit des erfindungsgemäßen Kopiermaterials wird deutlich, wenn die hergestellte Druckplatte einem Lagertest bei 100 °C ausgesetzt wird. Noch nach einer Lagerzeit von 4 Stunden läßt sich die erfindungsgemäße Druckplatte nach der bildmäßigen Belichtung einwandfrei entwickeln, während eine Druckplatte, die Hexamethylolmelaminhexamethylether enthält, bereits nach einstündiger Lagerung bei 100 °C nach dem anschließenden bildmäßigen Belichten sich nicht mehr einwandfrei entwickeln läßt.

In den folgenden Beispielen werden weitere Beschichtungslösungen angegeben, womit man ähnliche Ergebnisse erhält, wie sie in Beispiel 1 angegeben sind. Wenn nicht gesondert vermerkt, entsprechen Herstellung und Verarbeitung der damit erhaltenen Druckplatten den in Beispiel 1 beschriebenen Bedingungen.

### Beispiel 2

Die Beschichtungslösung besteht aus:
1,600 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
8,500 Gt eines Kresol-Formaldehyd-Novolaks mit einem Erweichungspunkt von 127 - 145 °C,
0,600 Gt 2,4,6-Tris-(4-methylphenoxy)-s-triazin,
0,040 Gt 2,4-Bis-trichlormethyl-6-p-stilbenyl-s-triazin,
0,900 Gt 2,4-Dihydroxybenzophenon und
0,080 Gt Kristallviolett in
90,00 Gt Propylenglykolmonomethylether und
60,00 Gt Tetrahydrofuran

### Beispiel 3

Die Beschichtungslösung besteht aus:
1,600 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
8,500 Gt eines Kresol-Formaldehyd-Novolaks mit einem Erweichungspunkt von 127 - 145 °C,
0,500 Gt 2,4,6-Tris-(4-isobutylphenoxy)-s-triazin,
0,040 Gt 2,4-Bis-trichlormethyl-6-p-methoxystyryl-s-triazin,
0,800 Gt 2,4-Dihydroxybenzophenon und
0,070 Gt Kristallviolett in einem Gemisch von
90,00 Gt Propylenglykolmonomethylether und
60,00 Gt Tetrahydrofuran

### Beispiel 4

Die Beschichtungslösung besteht aus:
1,600 Gt des Veresterungsproduktes aus 1 Mol 4-(2-Phenyl-prop-2-yl)-2,6-dibromphenol und 1 Mol Naphthochinon(1,2)-diazid-(2)-4-sulfonsäurechlorid,
8,500 Gt eines Kresol-Formaldehyd-Novolaks mit einem Erweichungspunkt von 127 - 145 °C,
0,500 Gt 2,4,6-Tris-(4-nitrophenoxy)-s-triazin,
0,040 Gt 2,4-Bis-trichlormethyl-6-p-stilbenyl-s-triazin,
0,800 Gt 2,4-Dihydroxybenzophenon und
0,070 Gt Kristallviolett in einem Gemisch aus
90,00 Gt Propylenglykolmonomethylether und
60,00 Gt Tetrahydrofuran

### Beispiel 5

Mit einer Lösung aus:
1,600 Gt eines Polyacetals, hergestellt aus Triethylenglykol und 2-Ethyl-butyraldehyd,
0,300 Gt 2,4-Bis-trichlormethyl-6-p-stilbenyl-s-triazin,
4,800 Gt eines Kresol-Formaldehyd-Novolaks mit einem Erweichungspunkt von 127 - 145 °C,
0,500 Gt 2,4,6-Tris-(4-ethoxycarbonyl-phenoxy)-s-triazin,
0,050 Gt Kristallviolett-Base in
50,00 Gt Propylenglykolmonomethylether und
30,00 Gt Tetrahydrofuran
wurde eine elektrochemisch aufgerauhte und anodisierte Aluminiumplatte beschichtet. Das so hergestellte hochlichtempfindliche Kopiermaterial wurde unter einer transparenten Positiv-Vorlage mit Hilfe einer Metall-Halogenid-Lampe von 500 Watt bei einem Lampenabstand von 103 cm mit 20 Takten bildmäßig belichtet und anschließend mit einer 6 %igen Lösung von Natriumsilikat entwickelt. Nach dem Entwickeln wurde eine der Vorlage entsprechende Positiv-Druckschablone erhalten.

Eine andere Probe des gleichen vorsensibilisierten Kopiermaterials wurde als Negativ-Druckplatte verarbeitet. Zu diesem Zweck wurde die Probe unter einer negativen Vorlage, wie oben angegeben, belichtet, anschließend 2 Minuten auf 130 °C erwärmt und dann ohne Vorlage dieselbe Zeit wie bei der bildmäßigen Belichtung nachbelichtet. Beim Entwickeln im gleichen Entwickler entstand das Umkehrbild der Vorlage. Der Umkehrspielraum, d.h. der Temperaturbereich, innerhalb dessen die bildmäßig belichtete Druckplatte während 2 Minuten ohne nachteilige kopiertechnische Eigenschaften erwärmt werden kann, betrug 80 - 143 °C.

### Beispiel 6

Die Beschichtungslösung besteht aus:
1,600 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
1,400 Gt eines Kresol-4-Isobutylphenol-Formaldehyd-Novolaks mit einem Erweichungspunkt von 115 - 125 °C,
6,000 Gt eines Copolymerisats aus Brenzcatechinmethacrylsäure und Styrol im Molverhältnis 70 : 30
0,700 Gt 2,4,6-Tris-(2,4,6-tribromphenoxy)-s-triazin,
0,700 Gt Bis-(4-hydroxyphenyl)-sulfon
0,040 Gt 2,4-Bis-trichlormethyl-6-p-stilbenyl-s-triazin und
0,070 Gt Kristallviolett in
90,00 Gt Propylenglykolmonomethylether und
60,00 Gt Tetrahydrofuran.

Die Herstellung und Verarbeitung der mit dieser Lösung erhaltenen Druckplatte entspricht den in Beispiel 1 beschriebenen Bedingungen. Es werden gleich gute kopiertechnische Ergebnisse erhalten, insbesondere ein ausgezeichneter Bildkontrast nach dem Belichten und nach dem Entwickeln und ein relativ großer Umkehrspielraum, der zwischen 110 und 150 °C liegt.

### Beispiel 7

Die Beschichtungslösung besteht aus:
1,600 Gt des Veresterungsproduktes aus 1 Mol 4-(2-Phenyl-prop-2-yl)-phenol und 1 Mol Naphthochinon(1,2)-diazid-(2)-4-sulfonsäurechlorid,
8,500 Gt eines Kresol-Formaldehyd-Novolaks mit einem Erweichungspunkt von 127 - 145 °C,
0,700 Gt 2,4,6-Tris-(4-methoxycarbonylethen-phenoxy)-s-triazin,
0,040 Gt 2,4-Bis-trichlormethyl-6-p-stilbenyl-s-triazin,
0,900 Gt 2,4-Dihydroxybenzophenon und
0,080 Gt Kristallviolett in
90,00 Gt Propylenglykolmonomethylether und
60,00 Gt Tetrahydrofuran.

## Patentansprüche

1. Lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und einen symmetrischen Triazin-alkyl(aryl)ether als die thermische Härtung fördernde Substanz enthält, dadurch gekennzeichnet, daß als thermische Härtung fördernde Substanz eine Verbindung der allgemeinen Formel I 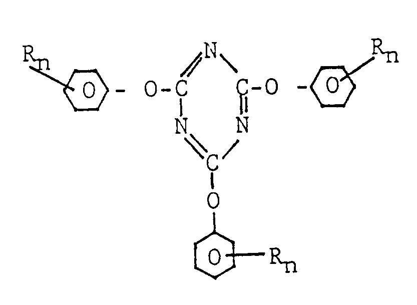 vorhanden ist,
worin
R Alkyl, Allyl, Alkoxy, Alkoxycarbonyl, Alkoxycarbonylalkenyl, mit jeweils 1-4 Kohlenstoffatomen in der Alkyl- oder Alkenyl-Gruppe, Aryloxy, Halogen oder die Nitrogruppe und
n 1 bis 3
bedeuten.

2. Gemisch nach Anspruch 1, dadurch gekennzeichnet, daß eine Verbindung nach der allgemeinen Formel I vorhanden ist,
worin
R Methyl, Isobutyl, Ethoxy, Ethoxycarbonyl, Methoxycarbonylethenyl, Brom oder die Nitrogruppe und
n 1 oder 3 bedeuten.

3. Lichtempfindliches Gemisch nach Anspruch 1, dadurch gekennzeichnet, daß es 0,5 bis 30 Gewichtsprozent, bezogen auf das Gewicht der nicht-flüchtigen Bestandteile des lichtempfindlichen Gemisches, an einer Verbindung der allgemeinen Formel I enthält.

4. Gemisch nach Ansprüchen 1 bis 3, dadurch gekennzeichnet, daß als thermische Härtung fördernde Substanz 2,4,6-Tris-(4-methylphenoxy)-s-triazin, 2,4,6-Tris-(4-ethoxycarbonyl-phenoxy)-s-triazin oder 2,4,6-Tris(2,4,6-tribromphenoxy)-s-triazin vorhanden ist.

5. Lichtempfindliches Kopiermaterial, aus einem Schichtträger und einer aufgebrachten lichtempfindlichen Schicht aus einem Gemisch nach Ansprüchen 1 bis 4.

6. Verfahren zur Herstellung von negativen Reliefkopien, bei dem man ein normalerweise positiv arbeitendes lichtempfindliches Kopiermaterial aus einem Schichtträger mit einer lichtempfindlichen Schicht aus einem Gemisch nach Ansprüchen 1 bis 4 verwendet, bildmäßig belichtet, danach erwärmt, nach dem Abkühlen vollflächig belichtet, dann mittels eines wäßrig-alkalischen Entwicklers entwickelt und gegebenenfalls anschließend tempert.

7. Verfahren nach Anspruch 6, dadurch gekennzeichnet, daß man das bildmäßig belichtete Material auf eine Temperatur im Bereich von 80 - 150 °C erwärmt.

8. Verfahren nach Anspruch 6 und 7, dadurch gekennzeichnet, daß man das bildmäßig belichtete Material 10 Sekunden bis 10 Minuten erwärmt.

9. Abänderung des Verfahrens nach Ansprüchen 6 bis 8, dadurch gekennzeichnet, daß man das Material zum Zusammenkopieren von Negativ- und Positivkopien nach dem Abkühlen mit Hilfe weiterer Vorlagen in den noch nicht belichteten, abgedeckten Schichtbereichen bildmäßig belichtet und dann mittels eines wäßrig-alkalischen Entwicklers entwickelt.

## Claims

1. Photosensitive composition substantially comprising a binder which is insoluble in water and soluble in aqueous-alkaline solutions, a photosensitive 1,2-quinonediazide or a photosensitive mixture comprising a compound which splits off acid upon exposure to light and a compound containing at least one acid-cleavable C-O-C group, and a symmetric triazine-alkyl(aryl)-ether as a substance which promotes thermal hardening, characterized in that a compound of the general formula I 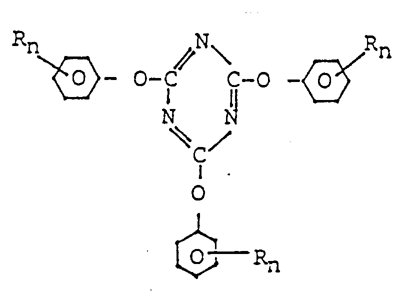 wherein
R denotes alkyl, allyl, alkoxy, alkoxycarbonyl, alkoxycarbonylalkenyl, each having from 1 to 4 carbon atoms in the alkyl or alkenyl group, aryloxy, halogen or the nitro group and
n stands for 1 to 3,
is present as the substance promoting thermal hardening.

2. A composition as claimed in claim 1, characterized in that a compound of the general formula I is present, wherein
R denotes methyl, isobutyl, ethoxy, ethoxycarbonyl, methoxycarbonylethenyl, bromine or the nitro group and
n stands for 1 or 3.

3. A photosensitive composition as claimed in claim 1, characterized in that it contains from 0.5 to 30 % by weight, based on the weight of the non-volatile constituents of the photosensitive composition, of a compound corresponding to the general formula I.

4. A composition as claimed in claims 1 to 3, characterized in that 2,4,6-tris-(4-methylphenoxy)-s-triazine, 2,4,6-tris-(4-ethoxycarbonyl-phenoxy)-s-triazine or 2,4,6-(2,4,6-tribromophenoxy)-s-triazine is present as the substance promoting thermal hardening.

5. Photosensitive copying material comprising a support and a photosensitive layer which is applied to the support and comproses a composition as claimed in claims 1 to 4.

6. Process for the production of negative relief copies, in which a normally positive-working photosensitive copying material comprising a support coated with a photosensitive layer of a composition as claimed in claims 1 to 4 is used, which is exposed imagewise, thereafter heated and, after cooling, subjected to an overall exposure, then developed by means of an aqueous-alkaline developer and optionally subsequently baked.

7. A process as claimed in claim 6, characterized in that the imagewise exposed material is heated to a temperature in the range from 80 ° to 150 °C.

8. A process as claimed in claims 6 and 7, characterized in that the imagewise exposed material is heated for 10 seconds to 10 minutes.

9. Modification of the process as claimed in claims 6 to 8, characterized in that, for producing negative and positive copies on the same copying layer, the material is, after cooling, exposed imagewise in the still unexposed, previously covered layer areas with the aid of additional originals and is then developed by means of an aqueous-alkaline developer.

## Revendications

1. Composition photosensible, qui contient essentiellement un liant soluble dans des solutions alcalines aqueuses et insoluble dans l'eau, un 1,2-quinonediazide photosensible ou un mélange photosensible à base d'un composé iibérant un aide par exposition à la lumière et d'un composé possédant au moins un groupe C-O-C clivable par un acide, et un éther de triazinyle symétrique et d'alkyl(aryle) , comme substance accélérant le durcissement thermique, caractérisée en ce que la substance présente, qui accélère la durcissement thermique, est un composé correspondant à la formule générale I, 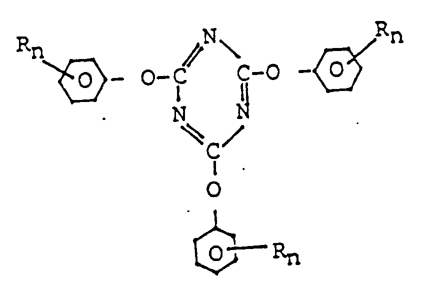 dans laquelle
R représente un qroupe alkyle, allyle, alcoxy, alcoxycarbonyle, alcoxycarbonylalcényle, le radical alkyle ou alcényle étant chaque fois en C₁₋₄, aryloxy, halogéno ou nitro, et
n vaut 1 à 3.

2. Composition selon la revendication 1, caractérisée en ce que le composé présent a la formule générale I dans laquelle R représente méthyle, isobutyle, éthoxy, éthoxycarbonyle, méthoxycarbonyléthényle, bromo ou nitro, et n vaut 1 ou 3.

3. Composition photosensible selon la revendication 1, caractérisée en ce qu'elle contient de 0,5 à 30 % en poids, par rapport au poids des constituants non volatils de la composition photosensible, d'un composé correspondant à la formule générale I.

4. Composition selon les revendications 1 à 3, caractérisée en ce qu'elle contient, comme substance accélérant le durcissement thermique, la 2,4,6-tris(4-méthylphénoxy)-s-triazine, la 2,4,6-tris(4-éthoxycarbonyl-phénoxy)-s-triazine ou la 2,4,6-tris(2,4,6-tribromophénoxy-s-triazine.

5. Matériau copiant photosensible, comprenenant un support sur lequel est déposée une couche photosensible à base d'une composition selon les revendications 1 à 4.

6. Procédé de production de copies an relief négatives, dans lequel on expose selon l'image un matériau copiant photosensible travaillant normalement en positif, qui comprend un support sur lequel est déposée une couche photosensible à base d'une composition revendiquée dans les revendications 1 à 4, puis on chauffe, on réalise ensuite une exposition sur toute la surface, après refroidissement, puis on développe au moyen d'un développateur hydro-alcalin et on procède éventuellement à une cuisson ultérieure.

7. Procédé selon la revendication 6, caractérisé en ce qu'on chauffe la matériau exposé selon l'image à une température de l'ordre de 80 à 150°C.

8. Procédé selon une des revendications 6 et 7, caractérisé en ce qu'on chauffe pendant 10 secondes à 10 minutes le matériau exposé selon l'image.

9. Variante du procédé selon les revendications 6 à 8, caractérisé en ce qu'on expose selon l'image, à l'aide d'autres originaux, le matériau, après refroidissement, pour le copiage simultané de négatifs et de positifs dans las zones de couche masquées non encore exposées, et qu'on le développe au moyen d'un développateur hydro-alcalin.
